# EUROPEAN PATENT APPLICATION

(11) **EP 2 562 933 A1**
(43) Date of publication of application: **27.02.2013**
(21) Application number: 11178896.4
(22) Date of filing: 25.08.2011
(51) Int. Cl.: H03F 3/217

(54) **Class D amplifier and control method**

(71) Applicant: NXP B.V., 5656 AG Eindhoven (NL)
(72) Inventor: Berkhout, Marco, Redhill, Surrey RH1 1DL (GB)
(74) Representative: Williamson, Paul Lewis

(57) **Abstract**

A Class D power amplifier is controlled such that the transition of the amplifier between the main output states (V_{PWM}=0 and V_{PWM}=1) includes intermediates state. In these intermediate states, the output stage is insensitive to changes in the PWM control signal. Each intermediate state is terminated by a respective timing signal having a transition before the next correct transition in the PWM control signal (comp).

## Description

This invention relates to Class D amplifiers.

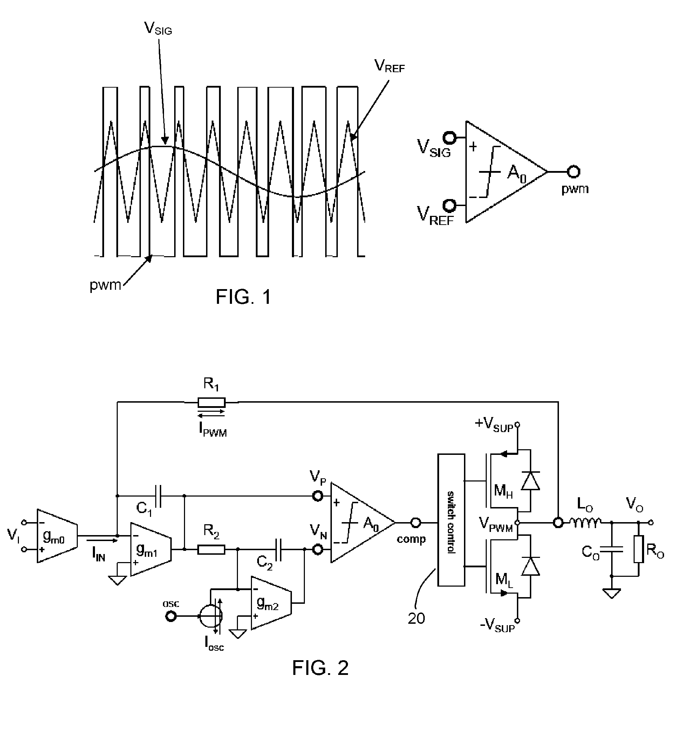

Class-D amplifiers are commonly used as speaker drivers in consumer, automotive and mobile applications. In most Class-D amplifiers some form of pulse-width modulation (PWM) is applied. A PWM signal can be constructed in a feed-forward manner by simply comparing the input signal V_{SIG} with a triangular reference wave V_{REF} as shown in Figure 1. Usually the frequency of the reference wave V_{REF} is much higher than that of the input signal V_{SIG}, e.g. around 350kHz.

Ideally, the spectrum of the PWM signal does not contain harmonics of the modulating signal, which means it can be considered ideal in terms of distortion. Many Class-D amplifiers use an integrating feedback loop to provide power supply rejection and correction of switching errors in the output stage. An example of such a feedback loop is shown in Figure 2.

The operation of this loop is described in detail in Berkhout, M., "An Integrated 200-W Class-D Audio Amplifier", IEEE Journal of Solid-State Circuits, vol.38, no.7, pp. 1198-1206, 2003.

The loop has two integrators configured around amplifiers gₘ₁ and gₘ₂. The output signal V_{PWM} of the amplifier is a square wave pulse-width modulated (PWM) signal. The load Rₒ is connected to the amplifier by means of a low-pass LC-filter (components Lo and Co).

The circuit comprises an output stage, shown in this example as a single output half-bridge comprising opposite type first, highside transistor M_{H}, and second lowside transistor M_{L} in series between power rails (V_{SUP} and -V_{SUP}). Note that a configuration with only NMOS transistors is also possible (as is shown in the paper "An Integrated 200-W Class-D Audio Amplifier" referenced above).

The feedback loop, with the two integrators and a comparator A₀, generates a PWM control signal ("comp") from an input signal (Vi) and from the amplifier output. The PWM control signal ("comp") controls the switching that takes place in the output stage.

The switching signals for the transistors in the output stage are generated by a controller 20, and this defines a first PWM output state with a high output voltage (V_{PWM}=1) and a second opposite PWM output state with a low output voltage (V_{PWM}=0).

Within the feedback loop, the output voltage V_{PWM} is converted to a current I_{PWM} by feedback resistor R₁ and injected into the virtual ground of the first integrator gₘ₁. This yields a triangular wave V_{P} at the output of the first integrator. A reference clock signal "osc" is converted to a square wave current l_{osc} that is injected into the virtual ground of the second integrator gₘ₂. This clock signal dictates the switching speed of the circuit - i.e. the PWM frequency, and the PWM duty cycle dictates the output level.

The clock signal yields a second (reference) triangular wave V_{N} at the output of the second integrator. The triangular wave signals V_{P} and V_{N} are fed to the non-inverting and inverting inputs of the comparator A₀.

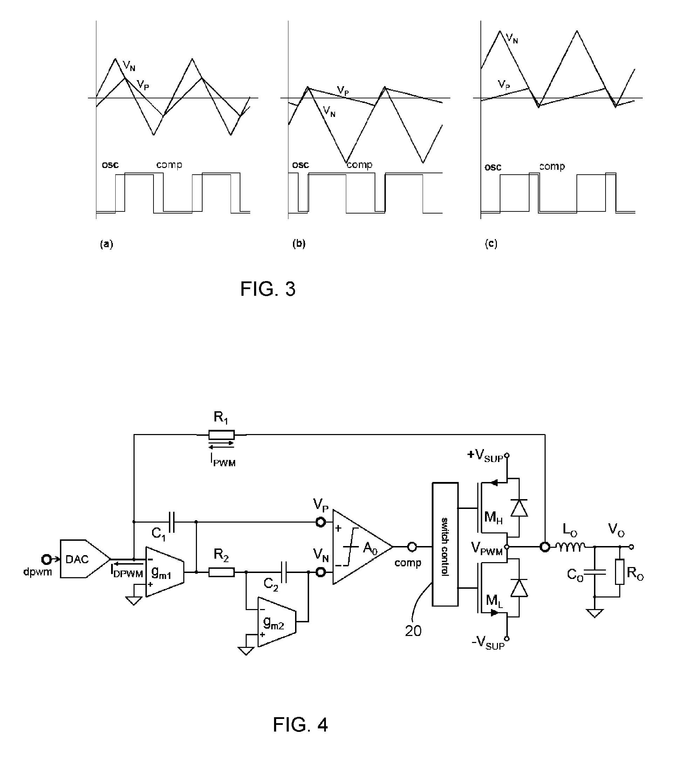

When the triangular waves intersect, the comparator output "comp" changes state, and the output V_{PWM} of the amplifier switches, yielding the desired PWM signal. The peaks (upper and lower) of signal V_{N} coincide with the edges of "osc" and the peaks (upper and lower) of signal V_{P} coincide with the edges of signal "comp" (as shown in Figure 3, discussed below).

The input signal is converted to a current I_{IN} by V-I converter gₘ₀ and injected into the virtual ground of the first integrator gₘ₁.

Figure 3(a) shows the triangular wave signals V_{P} and V_{N} at zero input yielding a 50% PWM duty-cycle.

Figure 3(b) shows the same signals when a positive input signal is applied. The input signal causes the slopes (and amplitude) of V_{P} to change. The shape of V_{N} remains (almost) the same but the DC-level is shifted with respect to zero. The output signal now has a duty-cycle greater than 50%.

The opposite happens for a negative input signal as shown in Figure 3(c).

In this manner, a linear relation is realized between the input signal and the duty cycle of the output signal V_{PWM}.

In Figure 3, it can be seen that during normal operation the rising and falling edges of the "osc" and "comp" signal follow a fixed sequence, i.e., a rising edge of the "comp" signal is always preceded by a rising edge of the "osc" signal and a falling edge of the "comp" signal is always preceded by a falling edge of the "osc" signal.

Another example of a class-D feedback loop is shown in Figure 4. This loop is very similar to the one shown in Figure 2 but here the input signal "dpwm" is in (digital) PWM format. A one-bit digital-to-analog converter (DAC) converts the input signal "dpwm" to an analog current I_{DPWM} that is injected into the virtual ground of the first integrator gₘ₁. Because the input signal is already in PWM format, no clock reference is needed. More detail on this design can be found in Berkhout, M. and L. Dooper, "Class-D Audio Amplifiers in Mobile Applications", IEEE Transactions on Circuits and Systems I: Regular Papers, vol.57, No.5, pp.992-1002, 2010.

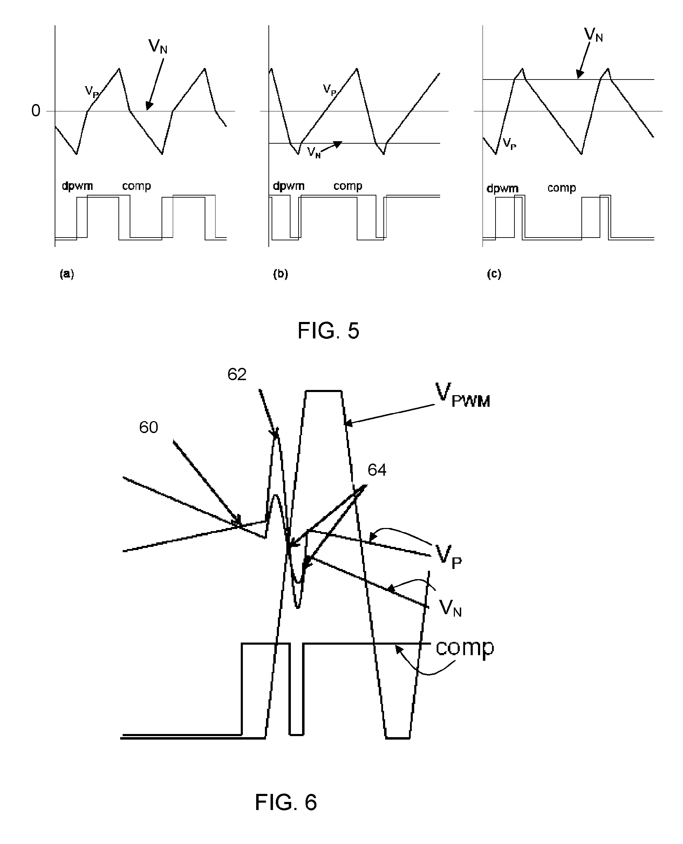

In Figure 5 the integrator signals V_{P} and V_{N} are shown in the case of zero, negative and positive modulation of the input signal "dpwm". Similarly to the operation of the circuit of Figure 2, there is a fixed sequence of the rising and falling edges of the "dpwm" and "comp" signals, i.e. a rising edge of the "comp" signal is always preceded by a rising edge of the "dpwm" signal and a falling edge of the "comp" signal is always preceded by a falling edge of the "dpwm" signal.

This fixed sequence implies that during one cycle of the "osc" signal in the circuit of Figure 2 or the "dpwm" signal in the circuit of Figure 4, the "comp" signal should have (at most) one rising and one falling edge.

It has been recognised (for example in US6577186), that during normal operation, the rising and falling edges of the "osc" and "comp" signal in a fixed frequency loop such as shown in Figure 2, follow a fixed sequence and this property can be exploited to detect the onset of clipping.

US 7965141 describes a method that limits the modulation depth in direct-PWM loops of the type shown in Figure 4, based on the insight that during normal operation the sequence of edges of the "dpwm" and "comp" signals is fixed.

A problem occurs if a disturbance is injected into the loops shown in Figure 2 and Figure 4 that causes an incorrect crossing at the comparator inputs V_{P} and V_{N}. An evident source of disturbance is the class-D output stage itself. Switching the output node can cause significant disturbance on the supply lines that couples to internal circuit nodes. This disturbance can be particularly high if the output current is high. In this case, the current is redirected abruptly from one supply rail to the other. The resulting current step in the supply lines in combination with the parasitic lead inductance causes significant voltage excursions on the internal supply nodes.

Figure 6 shows the disturbance of internal circuit nodes caused by output stage kickback.

In normal operation, the output stage switches shortly after the comparator inputs V_{P} and V_{N} in the loop intersect and are thus still very close to each other. A second intersection can occur if the disturbance caused by the switching of the output stage couples to the comparator inputs as is illustrated in Figure 6.

The first intersection 60 between V_{P} and V_{N} is the correct timing point which corresponds to the rising edge of the signal "comp". Disturbance from the rising edge of the PWM signal V_{PWM} is seen as a peak 62 in V_{N} and this gives rise to incorrect secondary intersections 64 between V_{P} and V_{N} which correspond to errors in the signal "comp".

This mechanism is called kickback. The incorrect intersections cause the output stage to switch which in turn causes a new disturbance. This can lead to a rapid cascade of pulses at the output.

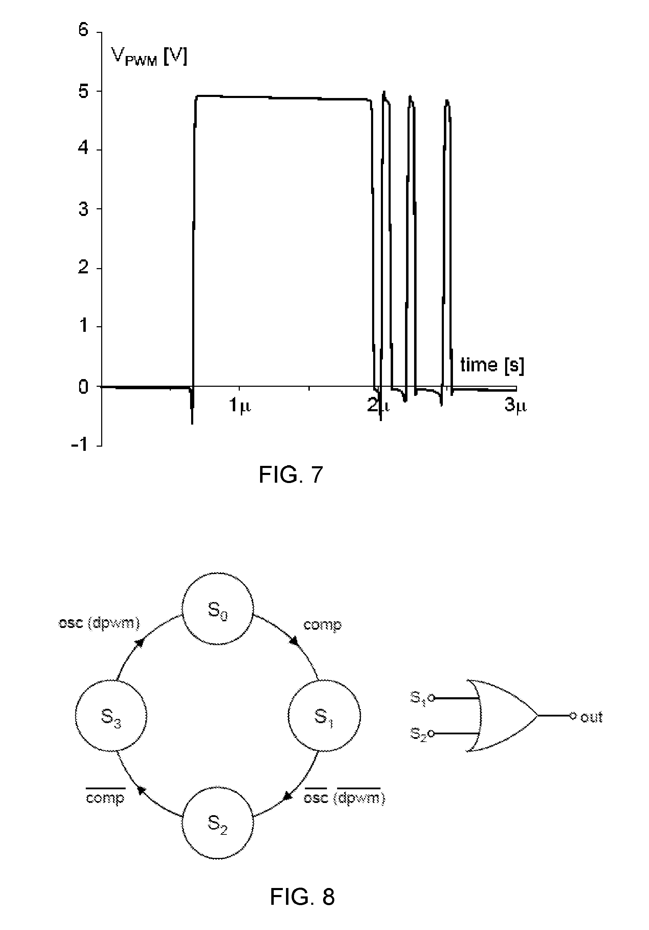

Figure 7 shows a simulation of a class-D amplifier with parasitic inductance in the supply line. As can clearly be seen, a series of three pulses follows the first falling edge.

Other sources of disturbance can have a similar effect.

For example, if the class-D amplifier has a bridge-tied-load configuration with a full-bridge output stage, the disturbance of one bridge-half can also be caused by the output stage of the other bridge-half. If the class-D amplifier is combined with a DC-DC boost converter the output stage of the boost converter can also be a source of disturbance.

The occurrence of incorrect pulses at the output is a problem for two reasons. First, it causes distortion. Second, it can cause damage to the device. This is because switching at high output current gives substantial peak dissipation in the class-D output stage. When these dissipation peaks occur only two times each clock cycle (∼2.6µs) this is not a problem but if they follow each other in rapid succession this can cause damaging increase in temperature.

The invention aims to prevent the occurrence of rapid spikes in the PWM output signal which result from these disturbances.

According to the invention, there is provided a Class D power amplifier for driving a load, comprising:
an output stage comprising at least one output half-bridge comprising first, highside, and second, lowside, transistors in series between power rails;
a feedback loop for generating a PWM control signal from an input signal and from the amplifier output, the PWM control signal controlling the output stage;
a controller for controlling the switching of the transistors of the output stage to define a first PWM output state with a high output voltage and a second opposite PWM output state with a low output voltage,
wherein the controller is adapted to:
   define a first intermediate state between the first and second PWM output states and define a second intermediate state between the second and first PWM output states, wherein in the first and second intermediate states, the output stage is insensitive to changes in the PWM control signal, and wherein each intermediate state is terminated by a respective timing signal having a transition before the next correct transition in the PWM control signal.

In this arrangement, repeated rapid switching of the output stage is avoided, even if transitions are present in the PWM control signal. These transitions may be present as a result of kickback effects, and the invention prevents these passing to the output of the amplifier circuit by defining intermediate states in which the output stage does not respond to such transitions. By using a timing signal which is known to have a transition before the next correct change in the PWM control signal, the intermediate states can have a duration which means they mask unwanted glitches in the PWM control signal but have a short enough duration that the next desired PWM control signal change feeds through to the output of the amplifier.

The controller can comprise an asynchronous logic circuit, and this is all that is required to implement the additional intermediate states. Existing switch control logic which is used to control the switching of the transistors of the output stage is adapted such that the desired intermediate states are defined.

The feedback loop can comprises a voltage to current converter for converting the output voltage to an output current, and an integrator circuit which receives as inputs an input current and the output current. The integrator circuit operates to define the PWM signal (in known manner) based on processing of current signals. It can comprise a one-stage integrator circuit, or more preferably a two-stage integrator circuit, which generates triangular waveforms.

The feedback loop preferably also comprises a comparator which receives signals from the integrator circuit and derives the PWM control signal (comp) as its output.

In one implementation, an input amplifier is provided for converting an analogue input voltage to the amplifier to an analogue input current, and the feedback loop comprises an oscillator signal which defines the operating frequency of the amplifier. In this case, the timing signal for one intermediate state can comprise the oscillator signal (osc) and for the other intermediate state can comprise the complementary signal of the oscillator signal. The oscillator signal defines the correct switching frequency of the amplifier, and by appropriate use of the transitions in the oscillator signal, the amplifier can be held in the intermediate states for long enough that rapid switching after an initial change in the PWM control signal is avoided, but the intermediate state has terminated before the next PWM control signal change.

In another implementation, an input digital to analogue converter is provided for converting a one bit digital pwm input signal to the amplifier to an analogue input current. This implementation avoids the need for an oscillator, as the digital input includes the required timing information. In this case, the timing signal for one intermediate state can comprise the digital input signal and for the other intermediate state can comprise the complementary signal of the digital input signal.

The invention also provides a method of controlling a Class D power amplifier which drives a load, the amplifier comprising:
an output stage comprising at least one output half-bridge comprising first, highside, and second, lowside, transistors in series between power rails; and
a feedback loop for generating a PWM control signal from an input signal and from the amplifier output, the PWM control signal for controlling the output stage, wherein the method comprises:
   controlling the switching of the transistors of the output stage to define a first PWM output state with a high output voltage and a second opposite PWM output state with a low output voltage; and
   defining a first intermediate state between the first and second PWM output states and defining a second intermediate state between the second and first PWM output states, wherein in the first and second intermediate states, the output stage is insensitive to changes in the PWM control signal, and wherein each intermediate state is terminated by a respective timing signal having a transition before the next correct transition in the PWM control signal.

Examples of the invention will be described with reference to the accompanying drawings, in which
Figure 1 shows conceptually how a PWM signal can be derived from an input signal;
Figure 2 shows a first known Class D amplifier generating a PWM control signal;
Figure 3 shows signals within the circuit of Figure 2 during: (a) zero input signal (b) positive input signal and (c) negative input signal;
Figure 4 shows a second known Class D amplifier generating a PWM control signal;
Figure 5 shows signals within the circuit of Figure 2 during: (a) zero input signal (b) positive input signal and (c) negative input signal;
Figure 6 shows how timing errors can arise in the circuits of Figures 2 and 4;
Figure 7 shows how timing errors can result in rapid switching of the amplifier output signal;
Figure 8 shows a state diagram to explain the control method of the invention; and
Figure 9 shows the improvement obtained by the control method of the invention.

A straightforward way of solving the disturbance problem described above is to shield the circuit from the disturbances by using supply decoupling and/or separate supply domains for the output stage and the sensitive analogue circuits in the feedback loop. However, this is not always possible because there may be a limitation on the number of available pins and external components that are allowed in the application.

The invention provides a Class D power amplifier in which the transition of the amplifier between the main output states (V_{PWM}=0 and V_{PWM}=1) is controlled such that intermediates state are defined. In these intermediate states, the output stage is insensitive to changes in the PWM control signal. Each intermediate state is terminated by a respective timing signal having a transition before the next correct transition in the PWM control signal.

The invention thus provides a solution in which the fixed sequence property described earlier is used. By doing so, incorrect output transitions can be filtered out in the digital domain between the comparator output and the output stage.

The sequence of edges in the control loop can be enforced by using a very simple asynchronous state-machine as shown in Figure 8.

In state S₀ of the amplifier, the (PWM) output "out" is low. If the signal "comp" goes high, the output stage switches to state S₁, the output "out" goes high and the switching of the transistors M_{H} and M_{L} of the output stage takes place. The state machine stays in state S₁ until a falling edge of "osc" (or "dpwm") occurs.

In state S₁, the switch control unit of the output stage is insensitive to the input signal to it (signal "comp"). The switching to state S₂ is only completed when the oscillator signal goes low (for the implementation of Figure 2) or the input signal "dpwm" goes low (for the implementation of Figure 4).

Similarly, in state S₂ of the amplifier, the (PWM) output "out" is high. If the signal "comp" goes low, the output stage switches to state S₃, the PWM output "out" goes low and the switching of the transistors M_{H} and M_{L} of the output stage again takes place. The state machine stays in state S₃ until a rising edge of "osc" (or "dpwm") occurs.

In state S₃, the switch control unit of the output stage is again insensitive to the input signal to it (signal "comp"). The switching to state S₀ is only completed when the oscillator signal goes high (for the implementation of Figure 2) or the input signal "dpwm" goes high (for the implementation of Figure 4).

In this way, each time the output stage is switched (by a change to the signal "comp"), there is a blanking period during which the output stage is insensitive to changes to the signal "comp". Thus, any glitches in the signal "comp" in the initial period after it has changed logical value, such as shown in Figure 6, are not fed through to the output stage, and thereby the corresponding glitches in the PWM output signal shown in Figure 7 are avoided.

The OR gate in Figure 8 shows that the output "out" (of the state machine) is high when the state machine is in states S₁ or S₂ and low in states S₃ and S₀. The states S₁ and S₃ are the intermediate states that are insensitive to the "comp" signal, and this is because the condition for jumping to the next state only depends on the "osc" (or "dpwm") signal. The state machine is inserted between the comparator output "comp" and the output stage. Thus, the output signal "out" of the state machine drives the output stage (the half-bridge circuit or circuits) by means of the switch control unit 20. Essentially, the state machine is extra logic which processes the conventional control signal "comp" to the switch control unit 20 to remove the glitches explained above, by reacting only to the initial transition on the "comp" signal. The state machine can be implemented as a modification to the switch control unit 20.

As long as the sequence of "comp" and the "osc" or "dpwm)" signals is satisfied, the state machine is transparent and the output signal out simply follows the "comp" signal.

If on the other hand the "comp" signal produces additional edges, the state-machine waits in either state S₁ or S₃ until the "osc" or "dpwm" signal changes sign. The incorrect edges of the "comp" signal caused by output stage kickback do not contain signal information so they can safely be discarded without deteriorating the output signal if the amplifier.

As can be seen in Figure 6, after the kickback disturbance has finished the integrator outputs revert to their original trajectories provided that the charge on the integrator capacitors is conserved.

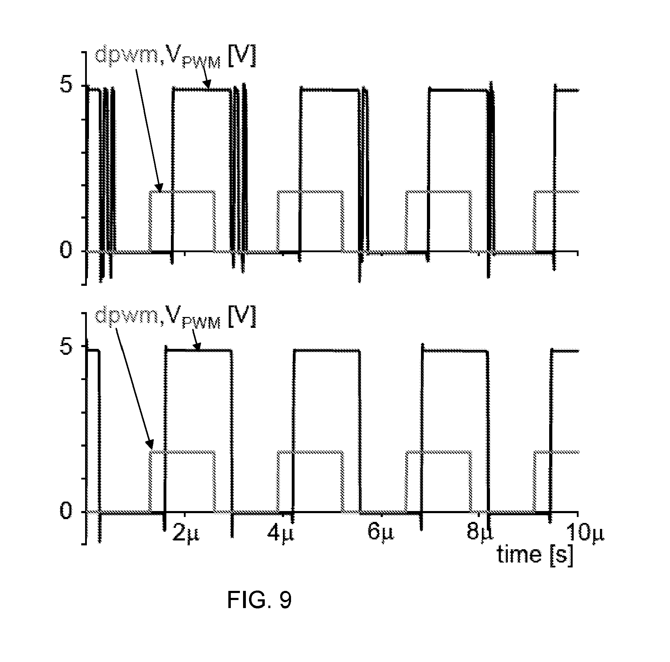

Figure 9 shows simulation results without and with the kickback logic active, applied to the circuit of Figure 4. The improvement is clear.

The invention has been described with reference to an amplifier with an output stage which comprises a single (half) bridge circuit. The invention can be applied to amplifier circuits with a bridge-tied-load configuration, in which a full-bridge output stage is used (two parallel branches of output transistors).

The invention described in this document is a logic function that can be implemented using standard CMOS or any other type of logic.

The invention can be used in class-D amplifiers generally, for example in audio amplifiers.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measured cannot be used to advantage. Any reference signs in the claims should not be construed as limiting the scope.

## Claims

1. A Class D power amplifier for driving a load, comprising:
an output stage comprising at least one output half-bridge comprising first, highside, and second, lowside, transistors (M_{H},M_{L}) in series between power rails;
a feedback loop (R₁, gₘ₁, gₘ₂, A₀) for generating a PWM control signal (comp) from an input signal (Vi; dpwm) and from the amplifier output, the PWM control signal (comp) controlling the output stage;
a controller (20) for controlling the switching of the transistors (M_{H},M_{L}) of the output stage to define a first PWM output state (S₂) with a high output voltage and a second opposite PWM output state (S₀) with a low output voltage,
wherein the controller (20) is adapted to:
define a first intermediate state (S₃) between the first and second PWM output states and define a second intermediate state (S₁) between the second and first PWM output states, wherein in the first and second intermediate states, the output stage is insensitive to changes in the PWM control signal (comp), and wherein each intermediate state is terminated by a respective timing signal having a transition before the next correct transition in the PWM control signal (comp).

2. An amplifier as claimed in claim 1, wherein the controller (20) comprises an asynchronous logic circuit.

3. An amplifier as claimed in any preceding claim, wherein the feedback loop comprises a voltage to current converter (R₁) for converting the output voltage to an output current (I_{PWM}) , and an integrator circuit (gₘ₁, gₘ₂) which receives as inputs an input current (I_{IN}) and the output current.

4. An amplifier as claimed in claim 3, wherein the feedback loop comprises a comparator (A₀) which receives signals from the integrator circuit and derives the PWM control signal (comp) as its output.

5. An amplifier as claimed in claim 3 or 4, comprising an input amplifier (gₘ₀) for converting an analogue input voltage to the amplifier to an analogue input current, and wherein the feedback loop comprises an oscillator signal (osc) which defines the operating frequency of the amplifier.

6. An amplifier as claimed in claim 5, wherein the timing signal for one intermediate state comprises the oscillator signal (osc) and for the other intermediate state comprises the complementary signal of the oscillator signal.

7. An amplifier as claimed in claim 3 or 4, comprising an input digital to analogue converter (DAC) for converting a one bit digital pwm input signal to the amplifier to an analogue input current.

8. An amplifier as claimed in claim 7, wherein the timing signal for one intermediate state comprises the digital input signal (dpwm) and for the other intermediate state comprises the complementary signal of the digital input signal.

9. A method of controlling a Class D power amplifier which drives a load, the amplifier comprising:
an output stage comprising at least one output bridge comprising first, highside, and second, lowside, transistors (M_{H},M_{L}) in series between power rails; and
a feedback loop (R₁, gₘ₁, gₘ₂, A₀) for generating a PWM control signal (comp) from an input signal and from the amplifier output, the PWM control signal (comp) for controlling the output stage, wherein the method comprises:
controlling the switching of the transistors (M_{H},M_{L}) of the output stage to define a first PWM output state (S₂) with a high output voltage and a second opposite PWM output state (S₀) with a low output voltage; and
defining a first intermediate state (S₃) between the first and second PWM output states and defining a second intermediate state (S₁) between the second and first PWM output states, wherein in the first and second intermediate states, the output stage is insensitive to changes in the PWM control signal, and wherein each intermediate state is terminated by a respective timing signal having a transition before the next correct transition in the PWM control signal (comp).

10. A method as claimed in claim 9, wherein the method comprises, in the feedback loop, converting the output voltage to an output current (I_{PWM}) , and processing an input current and the output current using an integrator circuit (gₘ₁, gₘ₂).

11. A method as claimed in claim 10, comprising deriving the PWM control signal (comp) using a comparator (A₀) which receives signals from the integrator circuit.

12. A method as claimed in claim 9 or 10, comprising converting an analogue input voltage to the amplifier to an analogue input current, and defining the operating frequency of the amplifier using an oscillator signal.

13. A method as claimed in claim 12, wherein the timing signal for one intermediate state comprises the oscillator signal (osc) and for the other intermediate state comprise the complementary signal of the oscillator signal.

14. A method as claimed in claim 10 or 11, comprising converting a one bit digital pwm input signal to the amplifier to an analogue input current.

15. A method as claimed in claim 14, wherein the timing signal for one intermediate state comprises the digital input signal (dpwm) and for the other intermediate state comprise the complementary signal of the digital input signal.
